# EUROPEAN PATENT APPLICATION

(11) **EP 1 975 120 A2**
(43) Date of publication of application: **01.10.2008**
(21) Application number: 08006052.8
(22) Date of filing: 28.03.2008
(51) Int. Cl.: B81C 1/00, B01L 3/00

(54) **Microchemical chip and method for fabricating the same**

(30) Priority: 29.03.2007 JP 2007089631
(71) Applicant: FUJIFILM Corporation, Minato-ku Tokyo 106-8620 (JP)
(72) Inventor: Fujiwara, Takayuki, Minami-Ashigara-shi, Kanagawa (JP); Miyoshi, Yoshiyuki, Minami-Ashigara-shi, Kanagawa (JP)
(74) Representative: HOFFMANN EITLE

(57) **Abstract**

A microchemical chip (10) having at least one micro channel (12) through which a hydrophilic fluid flows, comprises: a base plate (14) having a hydrophilic part which forms the micro channel on the surface of the plate; a top plate (16) disposed opposite and parallel to the base plate on the side of the micro channel of the base plate; and a channel height adjusting device (18) which adjusts a distance between the base plate and the top plate to adjust a channel height (H) of the micro channel.

## Description

### BACKGROUND OF THE INVENTION

### Field of the Invention

The present invention relates to a microchemical chip and a method for fabricating the same, and specifically relates to a technology for defining, in a highly accurate and simple manner, a channel height of a micro channel through which a fluid flows.

### Description of the Related Art

The search and development of microchemical chip for a chemical process using a chip of several square centimeters has been carried out. A use of microchemical chip provides an advantage that a result can be obtained using an extremely small amount of sample in a shorter time of period as compared to a macroscopic experimental apparatus in the prior art.

A microchemical chip has a plate made of a resin, a glass, quartz, or the like having a surface on which a micro channel is formed, and a sample (liquid or gas) is supplied to be flow through the micro channel, so that the ingredients of the sample is subjected to chemical processes including reaction, detection, refinement, separation, condensation, and mixture at a processing section which is provided at a certain point along the channel or at an end of the channel. The processing section includes a reacting section, a detecting section, a refining section, a separating section, a condensing section, and a mixing section.

The types of a microchemical chip include, for example, a chip for antigen-antibody reaction, a chip for DNA (genome) analysis, a chip for protein analysis, micro-TAS (total analysis system) for conducting various chemical processes, which are usually conducted in a laboratory, on a chip having a size of several square centimeters, a chip called as lab-on-chip or micro-reactor.

A micro channel is generally formed on a microchemical chip using a method for microfabricating a concave groove in a surface plate of the chip (R. M. McCormick, Analytical Chemistry, 1997, Vol. 69, p. 2626), but as disclosed in Japanese Patent Application Laid-Open No. 2000-42402 for example, another method has been also proposed in which a hydrophilic part is formed on a surface of a chip to provide a micro channel which is not a groove.

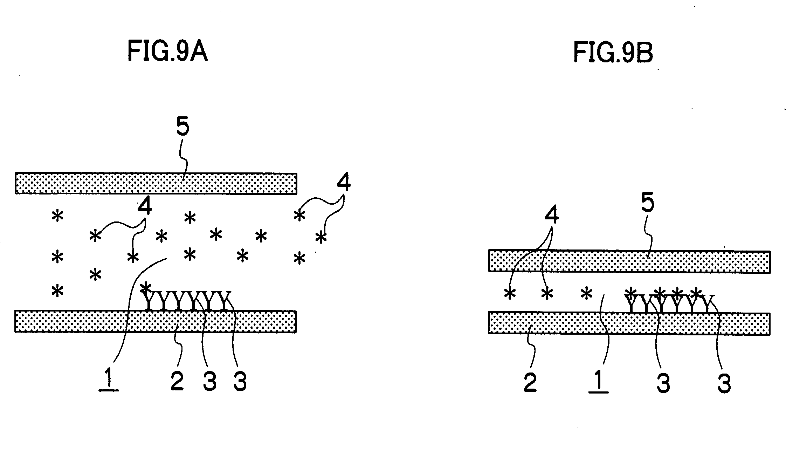

As in a microchemical chip for antigen-antibody reaction for example, when a blood serum is supplied to flow through a micro channel so that an antigen is trapped at a test section at a certain point along the channel for a test, a micro channel having a lower height provides higher trap efficiency, and improves the test accuracy. For, as shown in Fig. 9A, a micro channel 1 having a greater channel height H increases the ratio of antigens 4 in the blood serum which pass over antibodies 3 formed on a base plate 2, and decreases the possibility of the bonding between the antigens 4 and the antibodies 3. To the contrary, as shown in Fig. 9B, a micro channel 1 having a lower channel height H increases the chances for the contact between the antigens 4 and the antibodies 3, which increases the possibility of the bonding between the antigens 4 and the antibodies 3, and improves the quantitive reliability in detection.

However, when a channel height H is defined by a method in which a concave groove is formed in a surface of the base plate 2 to provide the micro channel 1, because the desired channel height H is extremely small on the order of nanometer or micrometer, there is a limit to the accuracy in machining a fine groove. Thus, a lower channel height H increases the influences of a variation in the accuracy in machining the groove onto the variation in the resulting channel heights H. The variation in the channel heights H increases the possibility that a top plate 5 which defines a height of the micro channel 1 partly contacts the base plate 2, and also the blood serum in the micro channel 1 flows smoothly at some parts and does not at some parts, which causes a reduction in accuracy of the test. Especially, in a case of a microchemical chip which requires high quantitative reliability, a variation in the channel heights H significantly affects its basic detection property.

Also, Japanese Patent Application Laid-Open No. 2000-42402 describes a method for fabricating a micro channel using hydrophilizing processing, but does not include any description about the approach for accurately defining a channel height. For the portability and simplicity of a microchemical chip, a bulky channel height adjusting apparatus is not preferable to use.

Therefore, in fabricating a microchemical chip, a height of the micro channel has to be adjusted in a highly accurate and simple manner, so that a microchemical chip that can be fabricated at a low cost and has quantitative reliability is achieved.

### SUMMARY OF THE INVENTION

The present invention was made in view of the above situation, and an object of the present invention is to provide a microchemical chip which can adjust a height of a micro channel in a highly accurate and simple manner, and can be fabricated at a low cost, and has quantitative reliability.

In order to achieve the above object, a first aspect of the present invention provides a microchemical chip having at least one micro channel through which a hydrophilic fluid flows, comprising: a base plate having a hydrophilic part which forms the micro channel on its surface; a top plate disposed opposite and parallel to the base plate on the side of the micro channel of the base plate; and a channel height adjusting device which adjusts a distance between the base plate and the top plate to adjust a channel height of the micro channel.

According to the first aspect, a micro channel is formed by forming a hydrophilic part on a surface of a base plate and a channel height is adjusted by using a channel height adjusting device which adjusts the channel height by adjusting a distance between a base plate and a top plate, instead of forming a micro channel by machining a groove. Therefore, the height of the micro channel can be adjusted in a highly accurate and simple manner, and a microchemical chip that can be fabricated at a low cost and has quantitative reliability is provided.

The micro channel formed on the hydrophilic part of the base plate allows a hydrophilic liquid/gas to flow along the micro channel even when the micro channel does not have side walls, but it is preferred to aggressively hydrophobe the surface of the base plate outside (around) the hydrophilic part. In this case, preferably the hydrophilic part of the micro channel has a water contact angle which is different from that of the surrounding hydrophobic part of the micro channel by 50 degrees or more.

According to a second aspect, in the microchemical chip according to the first aspect of the present invention, the micro channel has a channel height of from 1 nm to 5 mm inclusive.

An appropriate channel height of a microchemical chip is different depending on the application of the chip, but it is preferred to adjust the height within a range of from 1 nm to 5 mm inclusive. For example, a microchemical chip having a channel height of 1 nm can be formed by depositing a film having a thickness of 1 nm on a surface of a base plate formed of a silicon material using the evaporation method and connecting the base plate with a top plate by using the film as a spacer therebetween.

According to a third aspect, in the microchenical chip according to the second aspect of the present invention, when the micro channel has a side wall formed of a gas, the channel height is from 1 nm to 1 mm inclusive.

The upper limit of 1 mm of the channel height according to the third aspect indicates the holding limit of a liquid relative to a gas (for example, water to the air), and is the upper limit in a case where a micro channel has side walls formed of a gas. However, when a micro channel has side walls formed of a liquid such as oil (for example, see a sixteenth aspect) or an elastic solid (for example, see a seventeenth aspect), the upper limit of a channel height is increased to 5 mm.

According to a fourth aspect, in the microchemical chip according to any one of the first to third aspects of the present invention, the channel height adjusting device comprises: a spacer permanently or temporarily interposed between the base plate and the top plate and formed to have a thickness which defines the channel height; and a connecting device which connects the base plate and the top plate.

The channel height adjusting device according to the fourth aspect adjusts the channel height by interposing a spacer having a thickness which corresponds to a desired channel height between a base plate and a top plate, and connects the base plate and the top plate which were adjusted. A plate, such as a spacer, microfabricated to have a certain thickness improves the accuracy as compared to the accuracy in machining a fine groove, and enables to adjust a channel height with high accuracy.

According to a fifth aspect, in the microchemical chip according to any one of the first to third aspects of the present invention, the channel height adjusting device comprises: an adhesive layer interposed between the base plate and the top plate to connect the base plate and the top plate; and a plurality of particles contained in the adhesive layer and uniformly formed to have a particle size which defines the channel height.

The channel height adjusting device according to the fifth aspect has an adhesive layer which is interposed between a base plate and a top plate to adhesively connect these plates, and a plurality of particles having a particle size which corresponds to a desired channel height are mixed in the adhesive layer. This allows a channel height to be adjusted in a highly accurate and simple manner.

According to a sixth aspect, in the microchemical chip according to any one of the first to third aspects of the present invention, the channel height adjusting device is a double-sided adhesive tape formed to have a thickness which defines the channel height.

The channel height adjusting device according to the sixth aspect interposes a double-sided adhesive tape formed to have a thickness which defines the channel height between a base plate and a top plate, and is able to adjust a channel height in a highly accurate and simple manner.

According to a seventh aspect, in the microchemical chip according to any one of the first to third aspects of the present invention, the channel height adjusting device comprises: a bimetal which connects the base plate and the top plate; and a temperature control device which controls a temperature to be applied to the bimetal.

The channel height adjusting device according to the seventh aspect adjusts a distance between a base plate and a top plate so as to adjust a channel height by connecting the base plate and the top plate using a bimetal, and by expanding/contracting the bimetal by applying a predetermined temperature to the bimetal by a temperature control device. In this case, the relationship between the temperature applied to a bimetal and the distance between a base plate and a top plate may be found through tests in advance. This allows a channel height to be adjusted in a highly accurate and simple manner.

According to an eighth aspect, in the microchemical chip according to any one of the first to third aspects of the present invention, the channel height adjusting device comprises: a shape memory alloy which connects between the base plate and the top plate; and a temperature control device which controls a temperature to be applied to the shape memory alloy.

The channel height adjusting device according to the eighth aspect adjusts a distance between a base plate and a top plate so as to adjust a channel height by connecting the base plate and the top plate using a shape memory alloy, and causing the shape memory alloy to restore its original shape by applying a predetermined temperature to the shape memory alloy by a temperature control device. In this case, the relationship between the temperature applied to a shape memory alloy and the distance between a base plate and a top plate may be found through tests in advance. This allows a channel height to be adjusted in a highly accurate and simple manner.

According to a ninth aspect, in the microchemical chip according to any one of the first to third aspects of the present invention, the channel height adjusting device comprises: a piezoelectric element interposed between the base plate and the top plate; and a voltage control device which controls a voltage to be applied to the piezoelectric element.

The channel height adjusting device according to the ninth aspect adjusts a distance between a base plate and a top plate so as to adjust a channel height by interposing a piezoelectric element between the base plate and the top plate and applying a predetermined voltage to the piezoelectric element by a voltage control device. In this case, the relationship between the voltage applied to a piezoelectric element and the distance between a base plate and a top plate may be found through tests in advance. This allows a channel height to be adjusted in a highly accurate and simple manner.

According to a tenth aspect, in the microchemical chip according to any one of the first to third aspects of the present invention, the channel height adjusting device comprises: an elastic plate interposed between the base plate and the top plate; and a compressing device which can adjust a compressing force for compressing the elastic plate via the base plate and the top plate.

The channel height adjusting device according to the tenth aspect adjusts a distance between a base plate and a top plate so as to adjust a channel height by interposing an elastic plate between the base plate and the top plate and compressing the elastic plate via the base plate and the top plate by a compressing device. In this case, the relationship between an amount of a compressing force and a degree of compression of the elastic plate may be found through tests in advance based on the relationship between a compressing force applied by a compressing device and a reaction force of the compressed elastic plate. This allows a channel height to be adjusted in a highly accurate and simple manner.

According to an eleventh aspect, in the microchemical chip according to the tenth aspect of the present invention, the compressing device is a bolt member which connects the base plate and the top plate and adjusts a torque pressure.

As a compressing device, a bolt member which connects the base plate and the top plate and adjusts a torque pressure is used. In this case, the relationship between an amount of a compressing force and a degree of compression of the elastic plate may be found through tests in advance based on the relationship between a torque pressure applied by a bolt member and a reaction force of the compressed elastic plate.

According to a twelfth aspect, in the microchemical chip according to the tenth aspect of the present invention, the compressing device is magnets which are individually provided to the base plate and the top plate.

As a compressing device, magnets are provided to form an N pole and an S pole so as to adjust a compressing force depending on the strength of the magnetic force. In this case, the relationship between an amount of a magnetic force and a degree of compression of the elastic plate may be found through tests in advance based on the relationship between a strength of the magnetic force and a reaction force of the compressed elastic plate. An electromagnet may be used instead of the magnet to obtain a magnetic force which can be changed depending on an amount of the current flowing across the electromagnet, for more convenience.

According to a thirteenth aspect, in the microchemical chip according to the tenth aspect of the present invention, the compressing device is a compression case which comprises: a body container to receive a chip body having the elastic plate interposed between the base plate and the top plate; and a lid plate of the body container to close the body container and compress the elastic plate via the base plate and the top plate, and the channel height of the micro channel is automatically defined by the difference between the thickness of the chip body before the compression and the depth of the body container.

When a compression case is used as a compressing device, an elastic plate is compressed via a base plate and a top plate by putting the base plate and the top plate with the elastic plate being interposed therebetween into a container of the compression case and closing a lid of the container. Thus, the value obtained by subtracting a depth of the compression case from the total thickness of the base plate, the top plate, and the elastic plate before being put in the compression case is the amount to be compressed, and the value obtained by subtracting the compression amount from the thickness of the elastic plate before being put in is the channel height. Therefore, an appropriate setting of the total thickness and a depth of a compression case results in a desired channel height.

According to a fourteenth aspect, in the microchemical chip according to the thirteenth aspect of the present invention, the lid plate of the compression case is provided with a fluid supply port and an air vent hole in communication with the micro channel.

The fluid supply port and the air vent hole in communication with the micro channel formed in the lid plate of the compression case allow the microchemical chip to be used while the microchemical chip is received in the compression case.

According to a fifteenth aspect, in the microchemical chip according to one of the first to fourteenth aspects of the present invention, the part surrounding the hydrophilic part which forms the micro channel is hydrophobed.

The hydrophobed part which surrounds the hydrophilic part for the micro channel allows a fluid (suspension) to flow along only the micro channel without side walls of the micro channel, with a high accuracy.

According to a sixteenth aspect, in the microchemical chip according to any one of the first to fourteenth aspects of the present invention, the part surrounding the hydrophilic part which forms the micro channel is coated with a hydrophobic liquid having a high viscosity to form side walls of the micro channel.

According to the sixteenth aspect, side walls of the micro channel is formed from liquid, which can be achieved by coating a hydrophobic liquid having a high viscosity to the part surrounding the hydrophilic part for the micro channel. This allows a sample (liquid/gas) to flow along only the micro channel with a high accuracy.

According to a seventeenth aspect, in the microchemical chip according to any one of the first to fourteenth aspects of the present invention, the part surrounding the hydrophilic part which forms the micro channel is provided with a spacer which has a defined height for the micro channel or an elastic plate which has a changeable thickness to form side walls of the micro channel.

According to seventeenth aspect, because the side walls of the micro channel are formed with a spacer or an elastic body, even when the base plate and the top plate are formed with members having a small rigidity, the base plate and the top plate are not deformed, and the channel height can be maintained with a high accuracy. Preferably, the elastic plate has repellency.

In order to achieve the object of the present invention, an eighteenth aspect of the present invention provides a method for fabricating a microchemical chip having at least one micro channel through which a hydrophilic fluid flows, comprising: a micro channel forming step for forming a hydrophilic part which forms the micro channel on a surface of a base plate; a channel height adjusting step for interposing a spacer between the base plate and a top plate disposed opposite to the micro channel side of the base plate for defining a channel height of the micro channel; and a connecting step for connecting the base plate and the top plate in a state adjusted in the channel height adjusting step.

The eighteenth aspect of the present invention defines the steps for fabricating a microchemical chip according to the aspects of the present invention.

According to a nineteenth aspect, the method for fabricating a microchemical chip according to the eighteenth aspect of the present invention further comprises a pulling step for pulling out the spacer after the connecting step.

The nineteenth aspect of the present invention provides the method for fabricating a microchemical chip in which the spacer used for the channel height is pulled out after channel height is adjusted and the base plate and the top plate are connected to each other. This enables a fabrication of a number of microchemical chip in which a channel height is adjusted with a use of one spacer.

According to the present invention, a microchemical chip in which a height of a micro channel can be adjusted in a highly accurate and simple manner, and which can be fabricated at a low cost and has quantitative reliability can be provided.

### BRIEF DESCRIPTION OF THE DRAWINGS

Fig. 1 is a schematic view of a microchemical chip;
Fig. 2 is an exploded view showing an overview of a channel height adjusting device using a spacer;
Fig. 3 is an exploded view showing an overview of a channel height adjusting device using a particle-contained adhesive layer;
Fig. 4 is a schematic view illustrating a channel height adjusting device using a bimetal or a shape memory alloy;
Fig. 5 is a schematic view illustrating a channel height adjusting device using a piezoelectric element;
Fig. 6 is a schematic view illustrating a channel height adjusting device using a bolt with a torque adjuster as a compressing device;
Fig. 7 is a schematic view illustrating a channel height adjusting device using magnets as a compressing device;
Figs. 8A and 8B are schematic views illustrating a channel height adjusting device using a compression case as a compressing device; and
Figs. 9A and 9B are schematic views illustrating the influence of a channel height in an example of an antigen-antibody reaction.

### DETAILED DESCRIPTION OF THE PREFERRED EMBODIMENTS

Now, preferred embodiments of a microchemical chip and a method for fabricating the same according to the present invention will be explained below in detail by way of the accompanying drawings.

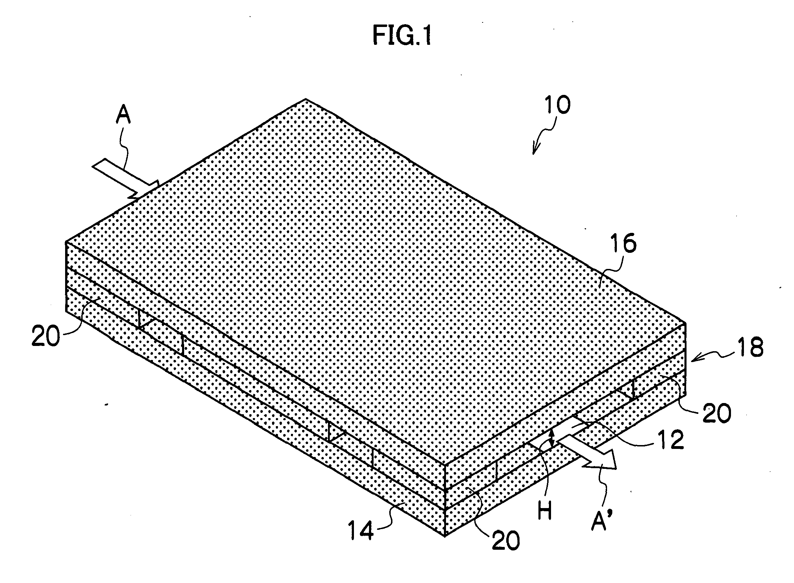

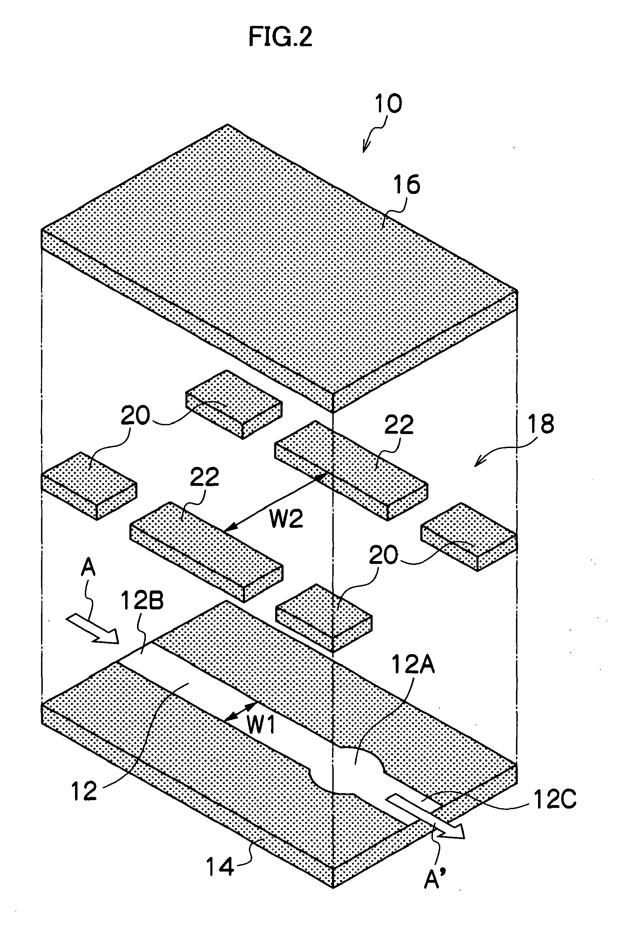

Fig. 1 is a schematic view illustrating an overview of a microchemical chip according to an embodiment of the present invention, and Fig. 2 is an exploded view of the microchemical chip.

As shown in Fig. 1 and Fig. 2, a microchemical chip 10 according to an embodiment of the present invention generally includes a base plate 14 having a surface on which a hydrophilic part which forms a micro channel 12, a top plate 16 disposed opposite and parallel to the base plate 14 on the side of the micro channel of the base plate 14, and a channel height adjusting device 18 which adjusts a distance between the base plate 14 and the top plate 16 to adjust a channel height H of the micro channel 12.

The micro channel 12 preferably has a channel width, which is the width of the hydrophilic part, of 100 µm to 5000 µm. The micro channel 12 has a channel height between the base plate and the top plate which is preferably within a range of from 1 nm to 5 mm inclusive, and is preferably less than 1 mm when side walls of the micro channel 12 are formed of a gas. A processing section 12A provided at a position along the micro channel 12 preferably has a surface area of 0.1 mm² to 5 mm².

A hydrophilic sample A (liquid or gas) is injected into the micro channel 12 from one end thereof (hereinafter, referred to as an injection section 12B), so that the sample A flows through the micro channel 12, and is subjected to chemical processes including reaction, detection, refinement, separation, concentration, and mixing of ingredients of the sample at the processing section 12A. A sample A' after the processes at the processing section 12A is discharged from the other end of the micro channel 12 (hereinafter, referred to as a discharge section 12C). The sample A may be injected into the injection section 12B preferably using an injection device for a small amount such as a micro-syringe. For example, when an antigen-antibody reaction is conducted in the microchemical chip 10, an antibody shown in Fig. 9 may be secured to the processing section 12A, and a blood serum may be injected into the injection section 12B of the micro channel 12 using a micro-syringe to bond the antigen in the blood serum with the antibody in the processing section 12A to carry out the antigen-antibody reaction. In this case, since the micro channel 12 is formed as a hydrophilic part, and the channel height H is a narrow gap within a range of from 1 nm to 5 mm inclusive, when a predetermined amount of the hydrophilic sample A is injected into the injection section 12B of the micro channel 12, the sample A flows along the micro channel 12 which is a hydrophilic part using the osmotic pressure as a driving force. Therefore, as shown in Fig. 2, even if the space W2 between spacers 20 (a space in the direction which sandwiches the micro channel 12) which will be described below is larger than the channel width W1 of the micro channel 12 and the micro channel 12 does not have a side wall, that is, the micro channel 12 has side walls of a gas (the air or the like), the sample A flows along the micro channel 12. In this case, when the base plate 14 and the top plate 16 are formed of a hydrophobic material, the micro channel 12 may be formed as a hydrophilic part, and also the surface of the base plate surrounding the outside of the micro channel 12 is preferably hydrophobed. This allows the sample A to flow along the micro channel 12 with a high accuracy. In this case, preferably the hydrophilic part of the micro channel 12 has a water contact angle which is different from that of the surrounding hydrophobic part of the micro channel 12 by 50 degrees or more.

As described above, when the micro channel 12 has no side walls, the base plate 14 and the top plate 16 should has a rigidity and a thickness to maintain the plates plane without deformation. However, when films having a small rigidity and a small thickness are used as the base plate 14 and the top plate 16, they tend to be deformed, which causes a distribution of channel heights. Therefore, in this case, side walls of the micro channel 12 should be formed so that the deformation of the base plate 14 and the top plate 16 can be prevented by the side walls. The side walls of the micro channel 12 can be formed by coating a hydrophobic liquid having a high viscosity, for example grease, onto a surface of the base plate surrounding the micro channel 12. Alternatively, a spacer which has a defined height for the micro channel 12 or an elastic plate which has a changeable thickness may be displaced onto a surface of the base plate surrounding the micro channel 12. In this case, the surface of the base plate surrounding the outside of the micro channel 12 does not have to be hydrophobed.

Next, each aspect of a channel height adjusting device 18 which adjusts the channel height H will be explained below.

The channel height adjusting device 18 of Fig. 2 mainly includes spacers 20 which are interposed between the base plate 14 and the top plate 16 and have a thickness defining the channel height H, and an adhesive layer 22 (connecting device) which connects the base plate 14 and the top plate 16.

In order to fabricate the microchemical chip 10 using the spacers 20, a hydrophilic part for the micro channel 12 is formed on a surface of the base plate 14 by a method such as deposition and coating (a micro channel forming step). Next, the spacers 20 which define the channel height H of the micro channel 12 are sandwiched between the base plate 14 and the top plate 16 opposite to the micro channel side of the base plate 14 (a channel height adjusting step). Then, the base plate 14 and the top plate 16 are fixedly attached to each other by the adhesive layer 22 (a connecting step). In Fig. 2, the adhesive layer 22 has a plate-like shape, but may have a spot shape to adhere the base plate 14 and the top plate 16 to each other at a plurality of points. In this way, the microchemical chip 10 is fabricated. After the connection of the base plate 14 and the top plate 16, a step for pulling out the spacers may be implemented. The removal of the spacers 20 allows them to be commonly used in fabricating a plurality of microchemical chips 10. If a plurality of spacers having different thicknesses for different applications of the microchemical chip 10 can be prepared, it is convenient because these spacers enable to quickly respond to a different channel height H.

According to the channel height adjusting device 18 using a spacer, a fabrication of a spacer 20 having a thickness corresponding to a desired channel height H with a high accuracy is all what is needed to adjust the channel height H of the micro channel 12 in a highly accurate and simple manner. In this case, it depends on the channel height H, but the opposite surfaces of the base plate 14 and the top plate 16 and the front and back surfaces of the spacer 20 are processed to a mirror finish having a mean roughness Ra of 10 nm or less. This condition can be applied to the following channel height adjusting devices. Also, not shown but, a double-sided adhesive tape having a thickness corresponding to a desired channel height H may be used instead of the spacer 20. In this case, an adhesive layer can be eliminated.

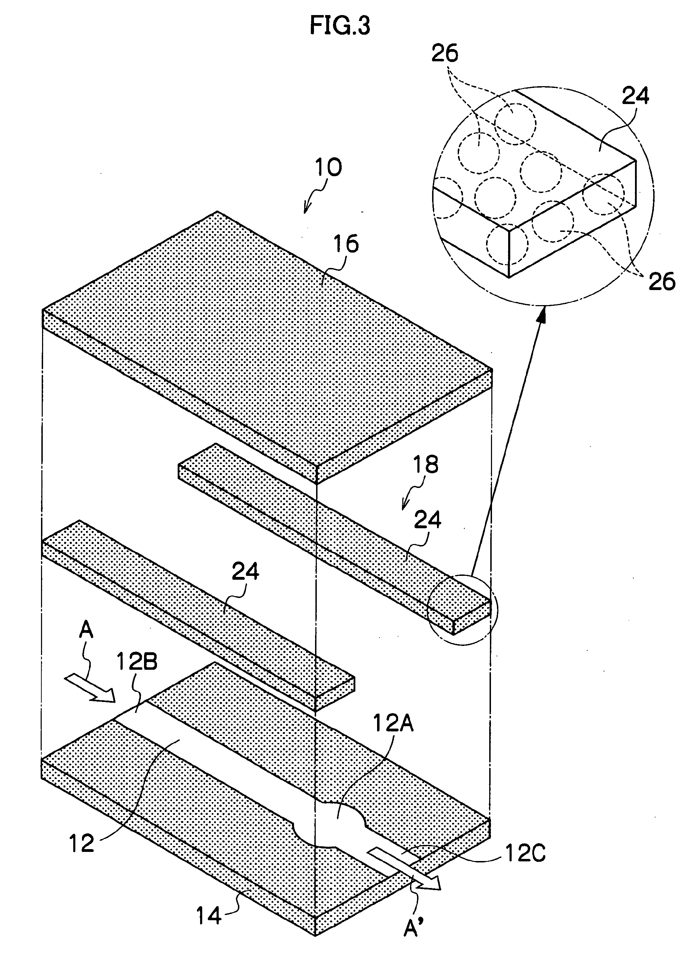

The channel height adjusting device 18 of Fig. 3 mainly includes an adhesive layer 24 interposed between the base plate 14 and the top plate 16 for connecting these plates, and plurality of particles 26 which are contained in the adhesive layer 24 and are uniformly formed to have a particle size which defines the channel height H. A fabrication of particle 26 having a particle size corresponding to a desired channel height H with a high accuracy is all what is needed to adjust the channel height H of the micro channel 12 in a highly accurate and simple manner.

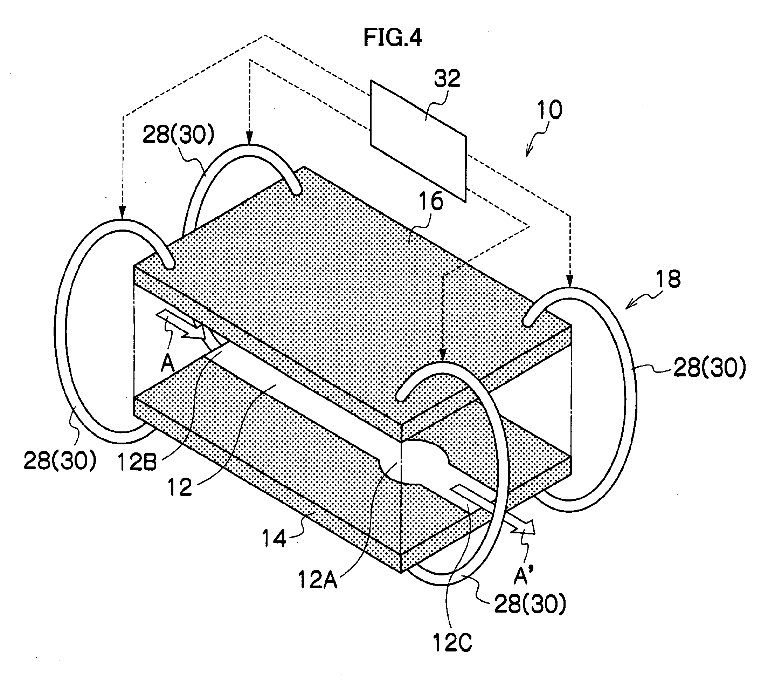

The channel height adjusting device 18 of Fig. 4 generally includes bimetals 28 or shape memory alloys 30 for connecting the base plate 14 and the top plate 16, and a temperature control device 32 which controls a temperature to be applied to the bimetals 28 or the shape memory alloys 30. In this case, the bimetals 28 or the shape memory alloys 30 are preferably used to connect the base plate 14 and the top plate 16 at the four corners thereof. According to the channel height adjusting device 18 using the bimetals 28, a recognition of the relationship between the temperature applied to the bimetals 28 and the space between the base plate 14 and the top plate 16 through tests in advance is all what is needed to adjust the channel height H in a highly accurate and simple manner. According to the channel height adjusting device 18 using the shape memory alloys 30, a recognition of the relationship between the temperature applied to the shape memory alloys 30 and the space between the base plate 14 and the top plate 16 through tests in advance is all what is needed to adjust the channel height H in a highly accurate and simple manner.

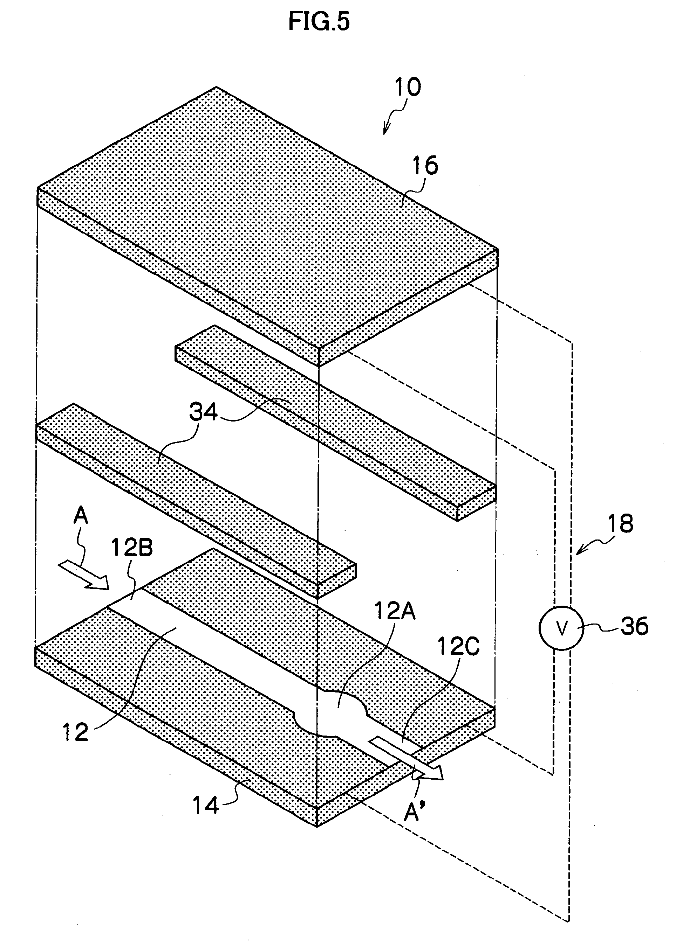

The channel height adjusting device 18 of Fig. 5 generally includes piezoelectric elements 34 interposed between the base plate 14 and the top plate 16, and a voltage control device 36 which controls a voltage to be applied to the piezoelectric elements 34. In this case, preferably electrode films (not shown) are formed on the surfaces of the base plate 14 and top plate 16 which are opposite to each other (except the micro channel 12) by deposition for example, and the electrode films and the voltage control device 36 are electrically connected each other. The piezoelectric elements 34 are preferably disposed on both sides of the micro channel 12 as a pair. According to the channel height adjusting device 18 using the piezoelectric elements 34, a recognition of the relationship between the voltage applied to the piezoelectric elements 34 and the space between the base plate 14 and the top plate 16 through tests in advance is all what is needed to adjust the channel height H in a highly accurate and simple manner.

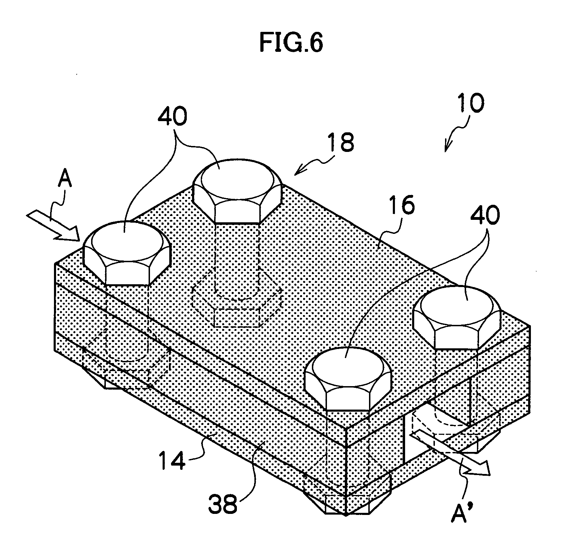

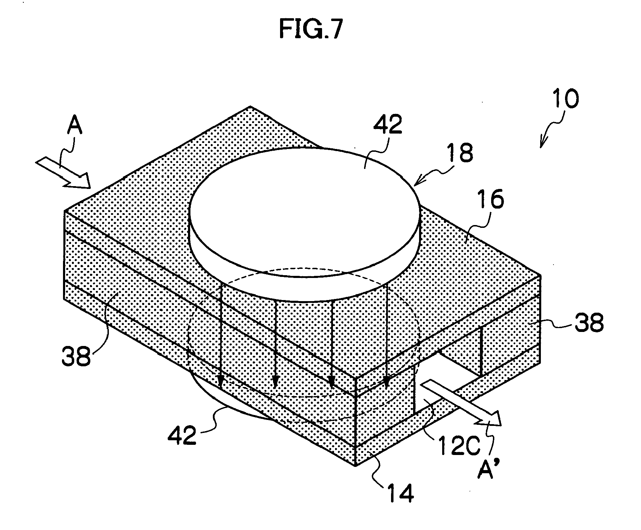

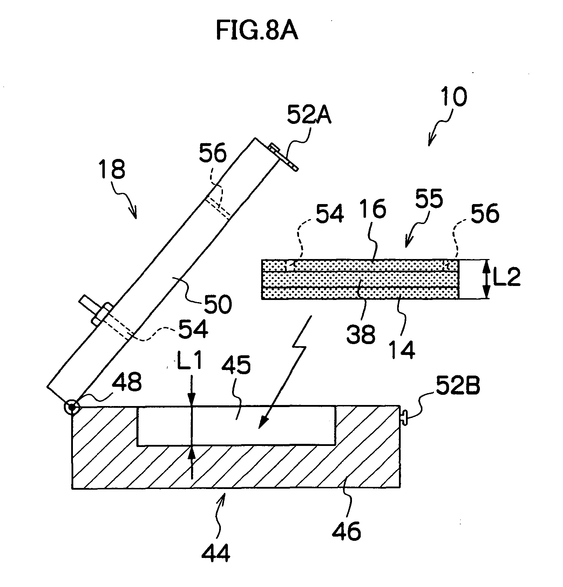

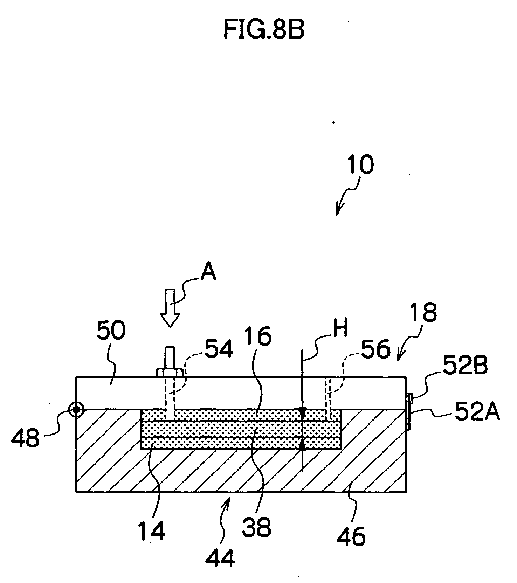

The channel height adjusting device 18 of Fig. 6 to Fig. 8 mainly include elastic plates 38 interposed between the base plate 14 and the top plate 16, and a compressing device which can adjust a compressing force for compressing the elastic plates 38 via the base plate 14 and the top plate 16. In this case, the elastic plates 38 are preferably disposed on both sides of the micro channel 12 as a pair. Fig. 6 shows an example in which bolts 40 are used as the compressing device, Fig. 7 shows an example in which magnets 42 are used as the compressing device, and Fig. 8 shows an example in which a compression case 44 is used as the compressing device.

The channel height adjusting device 18 of Fig. 6 uses bolts 40 having a torque adjuster as the compressing device, and is configured to detect the threaded amount of the bolts 40, that is the compression amount of the compressed elastic plates 38, using a torque pressure. According to the channel height adjusting device 18 using the bolts 40, a recognition of the relationship between the torque pressure of the bolts 40 and the compression amount of the elastic plates 38, that is the space between the base plate 14 and the top plate 16, through tests in advance is all what is needed to adjust the channel height H in a highly accurate and simple manner.

The channel height adjusting device 18 of Fig. 7 uses magnets 42 as the compressing device, and disc-shaped magnets 42 are fixedly attached to the outer surface of the base plate 14 and the outer surface of the top plate 16, these magnets 42 are individually attached so that an N pole and an S pole face each other. The configuration allows the N pole and the S pole to be attracted to each other by their magnetic forces, thereby a recognition of the relationship between the strength of the magnetic force and the compression amount of the elastic plates 38, that is the space between the base plate 14 and the top plate 16; through tests in advance is all what is needed to adjust the channel height H in a highly accurate and simple manner. Electromagnets may be used as the magnets 42 to obtain a magnetic force which can be changed depending on an amount of the current flowing across the magnets 42, for more convenience.

The channel height adjusting device 18 of Fig. 8 uses a compression case 44 as the compressing device. The compression case 44 includes a body container 46 having a rectangular space 45 which is open at the top thereof, a lid plate 50 pivotally connected to the body container 46 using a hinge 48, and fasteners 52A and 52B for fastening the lid plate 50 and the body container 46 to prevent an opening of the lid plate 50 while it is closed. The fasteners 52A and 52B is preferably a mechanism which achieves a fastening by an engagement between a hook 52A and a pin 52B as shown in Fig. 8. The lid plate 50 and the top plate 16 are provided with an injection hole 54 for injection of the sample A, and the injection hole 54 is in communication with a point close to the injection section 12B of the micro channel 12. And the lid plate 50 and the top plate 16 are also provided with an air hole 56 which is in communication with a point close to the discharge section 12C of the micro channel 12. The space of the body container 46 is formed to have a depth L1 which is smaller than a thickness L2 of the chip body 55 having the elastic plates 38 interposed between the base plate 14 and the top plate 16, by a compression amount.

In order to adjust the channel height H of the micro channel 12 using the channel height adjusting device 18 with the compression case 44 which is configured as described above, as shown in Fig. 8A, the chip body 58 having the elastic plates 38 interposed between the base plate 14 and the top plate 16 is put into the space 45 of the body container 46. Next, as shown in Fig. 8B, the lid plate 50 is closed to cause the hook 52A of the lid plate 50 to be engaged with the pin 52B of the body container 46. This causes the elastic plate 38 to be compressed via the base plate 14 and the top plate 16 to have a thickness of the channel height H. That is, the value obtained by subtracting a depth L1 of the compression case 44 from the total thickness L2 of the chip body 55 before being put in compression case 44 is a compression amount, and the value obtained by subtracting the compression amount from the thickness of the elastic plate 38 before being put in is the channel height H. Therefore, an appropriate setting of the total thickness L2 of the chip body 55 and a depth L1 of the compression case 44 results in a desired channel height H, and a channel height can be adjusted in a highly accurate and simple manner.

Next, the sample A is injected through an injection hole 54 of the lid plate 50 so that the sample A is subjected to chemical processes including reaction, detection, refinement, separation, concentration, and mixing of ingredients of the sample. After the chemical processes are completed, the lid plate 50 is opened to take the chip body 55 out. The base plate 14 and the top plate 16 are not connected to each other, which facilitates the removal of the sample A' in the micro channel 12.

According to the channel height adjusting device 18 using the compression case 44 which is configured as described above, a channel height H can be adjusted without using a connecting device which connects the base plate 14 and the top plate 16, and also chemical processes for the sample A can be carried out with the chemical chip being received in the compression case 44. The elastic plate 38 may be partly interposed between the base plate 14 and the top plate 16.

## Claims

1. A microchemical chip (10) having at least one micro channel (12) through which a hydrophilic fluid flows, comprising:
a base plate (14) having a hydrophilic part which forms the micro channel on its surface;
a top plate (16) disposed opposite and parallel to the base plate on the side of the micro channel of the base plate; and
a channel height adjusting device (18) which adjusts a distance between the base plate and the top plate to adjust a channel height (H) of the micro channel.

2. The microchemical chip (10) according claim 1, wherein
the micro channel (12) has a channel height of from 1 nm to 5 mm inclusive.

3. The microchemical chip (10) according to claim 2, wherein
when the micro channel (12) has a side wall formed of a gas, the channel height is from 1 nm to 1 mm inclusive.

4. The microchemical chip (10) according to any one of claims 1 to 3, wherein
the channel height adjusting device (18) comprises:
a spacer (20) permanently or temporarily interposed between the base plate (14) and the top plate (16) and formed to have a thickness which defines the channel height (H); and
a connecting device (22) which connects the base plate and the top plate.

5. The microchemical chip (10) according to any one of claims 1 to 3, wherein
the channel height adjusting device (18) comprises:
an adhesive layer (24) interposed between the base plate (14) and the top plate (16) to connect the base plate and the top plate; and
a plurality of particles (26) contained in the adhesive layer and uniformly formed to have a particle size which defines the channel height (H).

6. The microchemical chip (10) according to any one of claims 1 to 3, wherein
the channel height adjusting device (18) is a double-sided adhesive tape formed to have a thickness which defines the channel height (H).

7. The microchemical chip (10) according to any one of claims 1 to 3, wherein the channel height adjusting device (18) comprises:
a bimetal (28) which connects the base plate (14) and the top plate (16); and
a temperature control device (32) which controls a temperature to be applied to the bimetal.

8. The microchemical chip (10) according to any one of claims 1 to 3, wherein the channel height adjusting device (18) comprises:
a shape memory alloy (30) which connects the base plate (14) and the top plate (16); and
a temperature control device (32) which controls a temperature to be applied to the shape memory alloy.

9. The microchemical chip (10) according to any one of claims 1 to 3, wherein the channel height adjusting device comprises:
a piezoelectric element (34) interposed between the base plate (14) and the top plate (16); and
a voltage control device (36) which controls a voltage to be applied to the piezoelectric element.

10. The microchemical chip (10) according to any one of claims 1 to 3, wherein
the channel height adjusting device comprises:
an elastic plate (38) interposed between the base plate (14) and the top plate (16); and
a compressing device which adjusts a compressing force for compressing the elastic plate via the base plate and the top plate.

11. The microchemical chip (10) according to claim 10, wherein
the compressing device is a bolt member (40) which connects the base plate (14) and the top plate (16) and adjusts a torque pressure.

12. The microchemical chip (10) according to claim 10, wherein
the compressing device is magnets (42) which are individually provided to the base plate (14) and the top plate (16).

13. The microchemical chip (10) according to claim 10, wherein
the compressing device is a compression case (44) which comprises:
a body container (46) to receive a chip body having the elastic plate interposed between the base plate (14) and the top plate (16); and
a lid plate (50) of the body container to close the body container and compress the elastic plate (38) via the base plate and the top plate, and
the channel height (H) of the micro channel (12) is automatically defined by the difference between the thickness of the chip body before the compression and the depth of the body container.

14. The microchemical chip (10) according to claim 13, wherein
the lid plate (50) of the compression case (44) is provided with a fluid supply port (54) and an air vent hole (56) in communication with the micro channel (12).

15. The microchemical chip (10) according to any one of claims 1 to 14, wherein
a part surrounding the hydrophilic part which forms the micro channel (12) is hydrophobed.

16. The microchemical chip (10) according to any one of claims 1 to 14, wherein
the part surrounding the hydrophilic part which forms the micro channel (12) is coated with a hydrophobic liquid having a high viscosity to form side walls of the micro channel with a liquid.

17. The microchemical chip (10) according to any one of claims 1 to 14, wherein
the part surrounding the hydrophilic part which forms the micro channel (12) is provided with a spacer which has a defined height for the micro channel or an elastic plate which has a changeable thickness to form side walls of the micro channel with a solid.

18. A method for fabricating a microchemical chip (10) having at least one micro channel (12) through which a hydrophilic fluid flows, comprising:
a micro channel forming step for forming a hydrophilic part which forms the micro channel on a surface of a base plate (14);
a channel height adjusting step for interposing a spacer (20) between the base plate (14) and a top plate (16) disposed opposite to the micro channel side of the base plate for defining a channel height (H) of the micro channel; and
a connecting step for connecting the base plate and the top plate in a state adjusted in the channel height adjusting step.

19. The method for fabricating a microchemical chip (10) according to the claim 18, further comprising:
a pulling step for pulling out the spacer (20) after the connecting step.
